# EUROPEAN PATENT SPECIFICATION

(11) **EP 1 639 870 B1**
(45) Date of publication and mention of the grant of the patent: **17.11.2010**
(21) Application number: 04751551.5
(22) Date of filing: 07.05.2004
(51) Int. Cl.: H05K 1/02, H05K 7/20

(54) **MICROELECTRONIC SUBSTRATES WITH THERMALLY CONDUCTIVE PATHWAYS AND METHODS OF MAKING SAME**
MIKROELEKTRONISCHE SUBSTRATE MIT THERMISCH LEITENDEN EINSÄTZEN UND VERFAHREN ZU DEREN HERSTELLUNG
SUBSTRATS MICRO-ELECTRONIQUES INCLUANTS DES INSERTS THERMOCONDUCTEURS ET LEURS PROCEDES DE FABRICATION

(30) Priority: 07.05.2003 US 468801 P
(43) Date of publication of application: 29.03.2006
(73) Proprietor: Merix Corporation, Forest Grove, OR 97116 (US)
(72) Inventor: JOHNSON, Benny, H., Aloha, Oregon 97006 (US)
(74) Representative: Grünecker, Kinkeldey, Stockmair & Schwanhäusser Anwaltssozietät
(86) International application number: PCT/US2004/014209
(87) International publication number: WO 2004/103038

(56) References cited:
- US-A- 4 509 096
- US-A- 5 459 639
- US-A- 6 078 101
- US-B1- 6 188 579

## Description

This application claims the benefit of United States Provisional Application No. 60/468,801, filed 7 May 2003 and entitled "LAMINATED THERMAL MANAGEMENT COIN / SLUG FOR PRINTED CIRCUIT BOARDS".

This invention generally relates to microelectronic substrates, e.g., printed circuit boards (PCBs) or the like. Aspects of the invention are adapted to provide a thermally conductive pathway through the substrate to help dissipate heat.

Microelectronic components generate heat in use and can be damaged if they exceed acceptable operating temperatures. As high-energy microelectronic components become more prevalent and powerful the thermal load produced by these components becomes increasingly difficult to dissipate from the system.

Microelectronic components are commonly attached to a substrate such as a printed circuit board (PCB) to form a larger microelectronic component assembly. A single microelectronic component assembly will often have numerous microelectronic components, each of which generates heat in use, mounted on a single PCB. Dissipation of heat from the side of the PCB bearing the microelectronic components has been and continues to be a significant problem for PCB designers.

A variety of approaches are used in the art to dissipate heat generated by microelectronic components. One solution employs surface-mounted thermal risers with prongs or fins to dissipate heat to the air adjacent the PCB. Other approaches use arrays of copper plated holes (vias) that conduct the thermal load through the PCB and thence to a thermal mass, e.g., a chassis or housing for the microelectronic component assembly or a secondary heat sink on the back side of the finished assembly. One of the most effective thermal management devices is the use of a metal coin or slug to conduct the thermal load through the circuit board to such a thermal mass. After the PCB Is formed, e.g., by laminating multiple layers together, a through-opening or cavity may be machined through the thickness of the PCB, forming a passage between the component side and the back side of the PCB. Coins or slugs are then mounted in the opening or cavity using thermal grease or solder, typically as part of the component assembly process during which microelectronic components are mounted on the PCB.

The following patents, generally relate to PCB thermal management features:

U.S. Patent 5,779,134 **-** Method for surface mounting a heat sink to a printed circuit board

U.S. Patent 6,411,516 **-** Copper slug pedestal for a printed circuit board

U.S. Patent 6,190,941 **-** Method of fabricating a circuit arrangement with thermal vias

U.S. Patent 6,200,407 **-** Method of making a multilayer circuit board having a window exposing an enhanced conductive layer for use as an insulated mounting area.

US-A-5 459639 describes a printed board configuration having an opening employed on the board under the position where an electrical device is mounted on the board. The lateral size of the opening on the top side is larger than the size of the opening on the bottom side. To transfer the heat from the electrical device to the opposite side of the board, a thermal conductive element is employed in the opening. Specifically, the lateral dimensions of the thermal conductive element is larger at the top side and smaller at the bottom side.

It is the object of the present invention to provide an enhanced microelectronic substrate and a multilayer printed board including a thermal conductive element.

This is achieved by the features of the independent claims.

**Figure 1** is a schematic perspective view of a microelectronic component assembly in accordance with one embodiment.

**Figure 2** is a schematic cross-sectional view of the microelectronic component substrate of Figure 1, taken along line 2-2.

**Figure 3** is a schematic 3-D exploded cut-away view of a portion of the microelectronic component substrate of Figures 1 and 2.

**Figure 4** is a schematic 3-D laminated cut-away view of the portion of the microelectronic component substrate shown in Figure 3.

**Figure 5** is a schematic 3-D laminated close-up cut-away view of a portion of the microelectronic component substrate of Figure 4.

**Figure 6** is a schematic cross-sectional view of a portion of a microelectronic component substrate. This figure is for illustrative purposes only to better understand the present invention.

**Figure 7** is a schematic cross-sectional view of a portion of a microelectronic component substrate in accordance with another embodiment.

### DETAILED DESCRIPTION

### A. OVERVIEW

Various embodiments of the present invention provide microelectronic component assemblies and methods of manufacturing microelectronic component assemblies. The term "microelectronic component" may encompass a variety of articles of manufacture, including memory modules (e.g., SIMM, DIMM, DRAM, flash-memory), ASICs, processors, semiconductor wafers, semiconductor dies singulated from such wafers, or any of a variety of other types of microelectronic devices or components therefor. As used herein, "microelectronic component assembly" refers to at least one microelectronic component operatively coupled to a microelectronic component substrate and may include any number of microelectronic components or other structures, e.g., fin-bearing heat sinks. The more general term "microelectronic component" encompasses within its scope microelectronic component assemblies.

For ease of understanding, the following discussion is broken down into two areas of emphasis. The first section describes aspects of microelectronic component assemblies in certain embodiments of the invention. The second section outlines methods of manufacturing microelectronic component assemblies in accordance with other embodiments of the invention.

### B. MICROELECTRONIC COMPONENT ASSEMBLIES

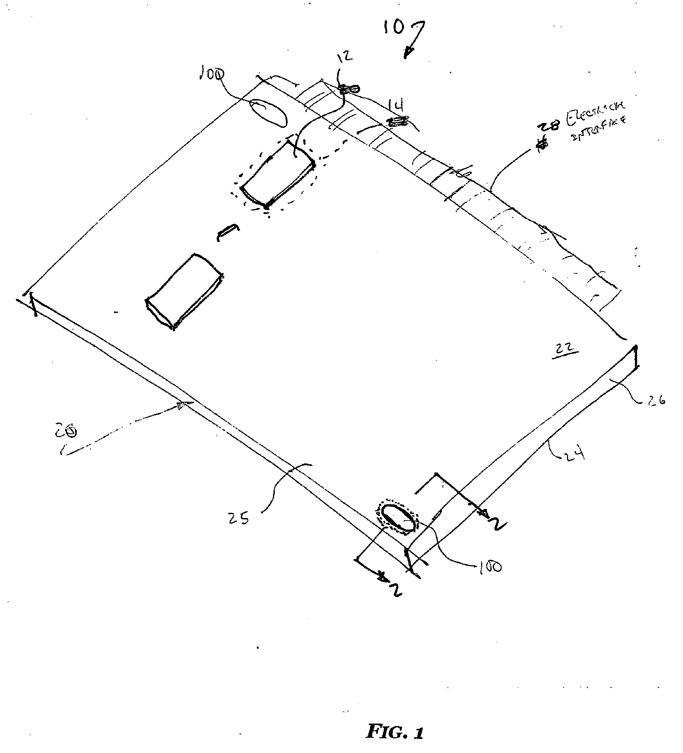

Figure 1 schematically illustrates a microelectronic component assembly 10 that generally includes a microelectronic substrate 20 that carries a number of microelectronic components 12. Each of the microelectronic components 12 may be mounted at a mounting site 14 (shown schematically in dashed lines) that is adapted to receive the particular microelectronic component 12 for mechanical and electrical connection to the microelectronic substrate 20. Any of a variety of known microelectronic components 12 may be attached to the microelectronic component substrate 30 in any manner known in the art.

The microelectronic component substrate 20 includes a body 25 that carries a thermally conductive member 100. The body 25 has a "front" surface 22 and a "back" surface 24 spaced apart from one another by a thickness T of the body 25. (Reference to "front" and "back" is solely for purposes of convenience and does not imply any particular orientation of the microelectronic component substrate 20.) A periphery 26 of the body 25 extends between the front and back surfaces 22 and 24. In the illustrated embodiment, the periphery 26 carries an electrical interface 28 to enable coupling of the microelectronic component assembly 10 to other microelectronic components (not shown), e.g., a bus of a computer that communicates with a series of other microelectronic component assemblies.

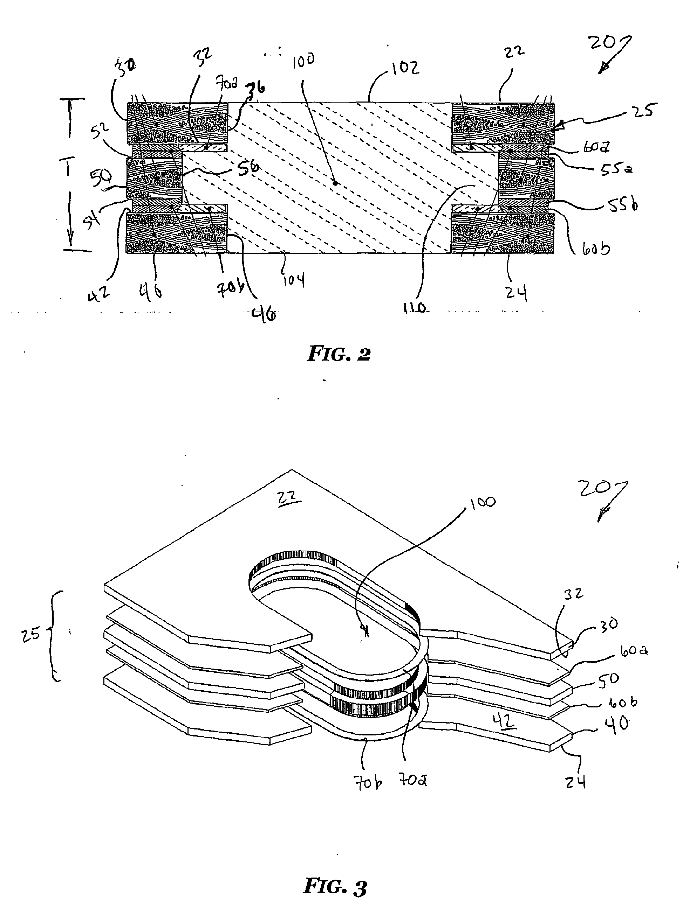

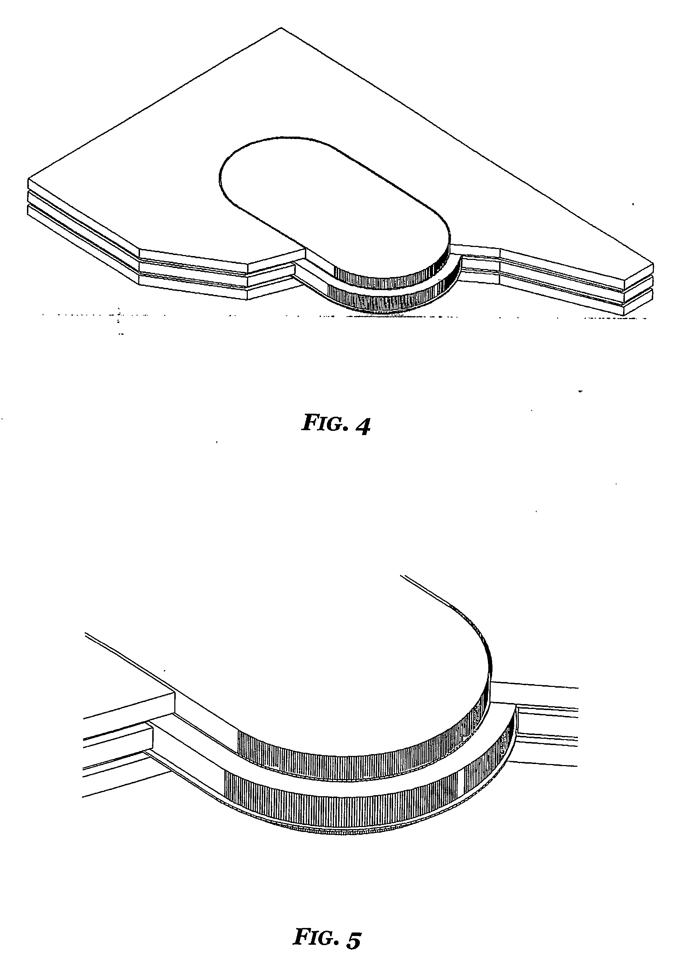

Figures 2-5 illustrate the microelectronic component substrate 20 of Figure 1 in greater detail. As shown in these drawings, the body 25 of this particular microelectronic component substrate 20 comprises a plurality of separate body layers that together define the overall thickness T of the body 25. In particular, the body 25 of Figures 2-5 includes a "front" body layer 30, a "back" body layer 40, and an intermediate body layer 50 disposed between the front and back body layers 30 and 40. In this arrangement, an inner surface 32 of the front body layer 30 is juxtaposed with a front surface 52 of the intermediate body layer 50. Likewise, an inner surface 42 of the back body 40 is juxtaposed with a back surface 54 of the intermediate body layer 50.

At least one of the body members 30, 40, and 50 may carry an electrically conductive layer 55 to which some or all of the microelectronic components 12 (Figure 1) are electrically coupled. As is known in the art, such an electrically conductive layer 55 typically comprises a metal layer that has been patterned to define an electrical circuit that interconnects the microelectronic components 12 to provide a functioning microelectronic component assembly 10. In the illustrated embodiment, the intermediate body layer 50 includes a first electrically conductive layer 55a on the front surface 52 and a second electrically conductive layer 55b on the back surface 54. In one embodiment, one of these electrically conductive layers 55 may function as a ground layer for the microelectronic component assembly 10.

Each of the body layers 30, 40, and 50 may comprise any of a variety of dielectric materials. For example, the body layers 30, 40, and 50 may comprise a relatively thin, flexible film to provide a flexible printed circuit. In other embodiments, the body layers 30, 40, and 50 may comprise a more rigid dielectric material, e.g., any material commonly employed in PCBs. In select embodiments, each of the layers 30, 40, and 50 may comprise a glass filament- and particulate-reinforced resins such as FR4, High TG FR4, or high performance RF materials. The material of body layers 30, 40, and 50 may be selected to achieve a particular electrical or thermal performance objective of the finished microelectronic component assembly 10. In the illustrated embodiment, each of the body layers 30, 40, and 50 are formed of the same material. In other embodiments, the layers 30, 40, and 50 may be different from one another.

As is known in the art, the body layers 30, 40, and 50 may be laminated together using an adhesive or other cementitious material. In Figures 2-5, a first adhesive layer 60a attaches the front body layer 30 to the intermediate body layer 50 and a second adhesive layer 60b attaches the back body layer 40 to the intermediate body layer 50. A wide variety of suitable adhesives are known in the art. If the body layers 30, 40, and 50 comprise FR4, any of a variety of commercially available FR4 adhesive materials may be used. In the embodiment shown in Figure 3, the adhesive layers 60a and 60b comprise a sheet that is preimpregnated with a suitable adhesive resin.

The front body layer 30 includes a first opening 36 that extends therethrough, the intermediate body layer 50 includes a second opening 56 that extends through its thickness, and the back layer 40 includes a third opening 46 therethrough. The second opening 56 extends outwardly beyond a periphery of at least one of the first and third openings 36 and 46. In the illustrated embodiment, the first and third openings 36 and 46 are about the same size and the second opening 56 extends outwardly beyond the periphery of both of those openings. As a consequence, a transverse recess is formed between the front and back body layers 30 and 40. This leaves a peripheral surface of the inner surface 32 juxtaposed with, but spaced from, a peripheral portion of the inner surface 42 of the back body layer 40.

The openings may be precisely machined using a CNC router or the like to create concentric openings to accommodate the thermally conductive members 100. The lamination adhesive layers 60 may be laser or die-cut to produce openings that match openings 36 and 46.

As noted above, the microelectronic substrate 20 includes one or more thermally conductive members or "slugs" 100, with two such thermally conductive members 100 being shown in the microelectronic component assembly 10 of Figure 1. The slugs 100 may comprise an integrally formed and suitably shaped piece of metal or other material that is more thermally conductive than the body 25. A polymeric material can be used as the thermally conductive member 100, in many embodiments the thermally conductive member 100 is a thermally conductive metal, e.g., copper or aluminum. If the slug 100 is to be electrically coupled to the conductive layers 55, copper and aluminum would meet that objective, as well.

The slug 100 includes a front thickness adjacent its front surface 102, a back thickness adjacent its back surface 104 and an intermediate thickness disposed between the front and back thicknesses. The intermediate thickness has a lateral dimension that is greater than the corresponding dimension of one or both of the front and back thicknesses. As a consequence, the slug 100 includes a transversely extending flange 110 that extends transversely outwardly into the recess between the front and back body members 30 and 40 of the body 25. The flange may define a shoulder that can be juxtaposed with and bonded to an attachment surface of each of the front and back body members 30 and 40 by means of a suitable adhesive 70. In the illustrated embodiment, the first attachment adhesive 70a may attach the flange 110 to the inner surface 32 of the front body member 30 and a second attachment adhesive 70b may attach the flange 110 to the inner surface 42 of the back body layer 40. These attachment adhesives 70 may be screen-printed or pre-formed. The adhesive may be thermally conductive and/or electrically conductive. If the adhesive 70 is electrically conductive, it can couple the slug to conductive layers 55 of the body 25.

By carefully specifying the thickness of the slug 100 to match the thickness of the body, good planarity with slight prominence of the slug 100 can be achieved. In some embodiments, slight prominence of the slug 100 may be desirable to provide good contact with a microelectronic component 12 while not over-stressing the components leads. In one exemplary design, the thickness of the coin can be slightly thicker than the thickness T of the body 25.

An embodiment where no electrical ground properties are required between the slug and the ground plane of the PCB is also foreseen.

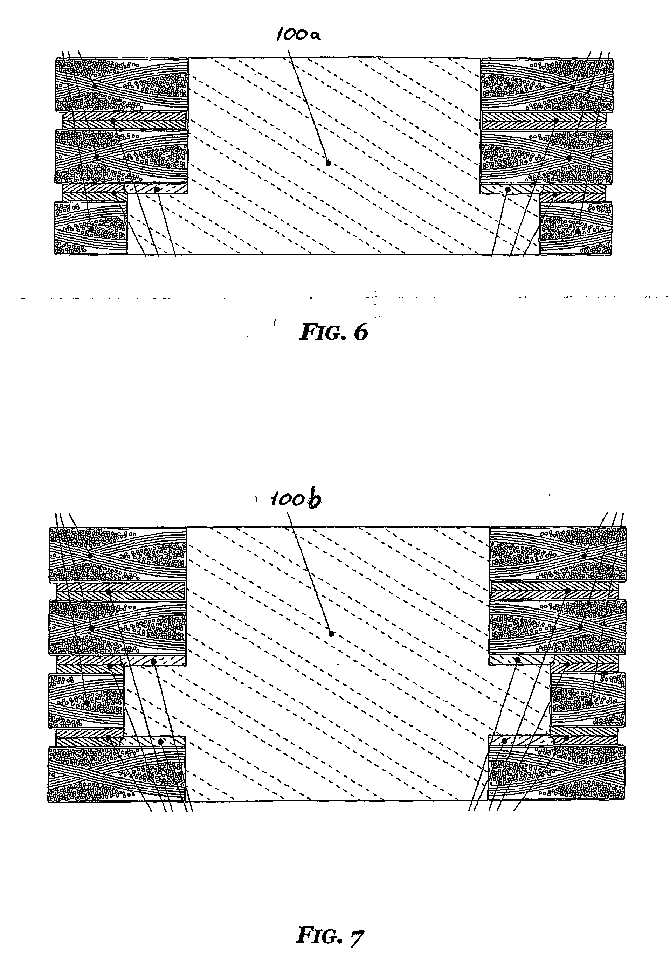

Figures 6 and 7 illustrate alternative designs with differently shaped slugs 100a and 100b. In Figure 6, the flange 110a is adjacent an end of the slug 100 but is recessed inside the back body layer. The substrate of Figure 7 includes more body layers, but the design and construction may otherwise parallel that discussed above. The flange may be located on either side (Figure 6) of the slug 100, in the center (Figure2-5) or off-center (Fig. 7).

Figure 6 illustrates a cross-sectional alternative design to the invention. This process of laminating the coin / slug directly in the PCB does not require and is not limited to the center located "flanged" detail. Other coin / slug designs including those illustrated and others which are not specifically depicted, may be suitable for use, too. Figure 6 shows a flange located on one side of the coin / slug and one layer of conductive adhesive material (4) providing ground connection to only one layer in the multilayer PCB. The rest of the PCB may comprise a standard design copper clad core material, and lamination adhesive material.

### C. METHODS OF MANUFACTURE

The exploded, 3-D cut-away view of Figure 3 schematically illustrates the relationship between the various components of the microelectronic component substrate 20 during manufacture. This view also suggests the sequence of assembly steps that are required to assemble the substrate 20.

The components of the substrate 20 may be assembled, referred to as a "collation lay-up," of the specific microelectronic component assembly of Figure 2 may follow the following sequence:

1. Back layer 40

2. Conductive adhesive material 70b

3. Slug 100

4. Lamination adhesive material 60b

5. Intermediate body layer 50

6. Lamination adhesive material 60a

7. Conductive adhesive material 70a

8. Front layer 30

This arrangement facilitates easy assembly of the microelectronic component substrate 20 and securely integrates the slug 100 in the structure for better mechanical and thermal connection.

Some advantages of select embodiments include:
a. By manufacturing PCB dielectric materials with concentric features allowing the coin / slug to be sized and toleranced to nest in the openings;
b. By manufacturing PCB compatible adhesive materials that align with the laminate features and coin / slug, which can facilitate assembly in conventional lamination presses; and/or
c. Selecting any of various cross-section coin / slug designs, e.g., designs having offset flanges or centerline flanges aligning with one or more layers in the PCB construction. Such a flange could be circumferential or limited to specific locations around the coin creating isolated protrusions.

The above-detailed embodiments of the invention are not intended to be exhaustive or to limit the invention to the precise form disclosed above. Specific embodiments of, and examples for, the invention are described above for illustrative purposes, but those skilled in the relevant art will recognize that various equivalent modifications are possible within the scope of the invention. For example, whereas steps are presented in a given order, alternative embodiments may perform steps in a different order. The various embodiments described herein can be combined to provide further embodiments.

Unless the context clearly requires otherwise, the words "comprises," "comprising," and the like are to be construed in an inclusive sense as opposed to an exclusive or exhaustive sense, i.e., in a sense of "including, but not limited to." In general, the terms used in this disclosure should not be construed to limit the invention to the specific embodiments described above unless the above-detailed description explicitly defines such terms. While certain aspects of the invention are presented above in certain exemplary embodiments, the inventors contemplate various aspects of the invention in any number of embodiments, within the scope of the appended claims.

## Claims

1. A microelectronic substrate comprising:
a body (25) having
a front surface (22) that includes a microelectronic component mounting site configured to receive a microelectronic component,
a back surface (24) separated from the front surface (22) by a thickness (T), and
an opening being outwardly open at the front surface (22) and the back surface (24), and having a first portion (36) having a first lateral opening dimension, and a second portion (56) having a second lateral opening dimension; and
a thermally conductive member (100), which has a thermal conductivity greater than a thermal conductivity of the body (25), received at least in part in the opening in the body (25), the thermally conductive member (100) having a first thickness received in the first portion (36) of the opening and a second thickness received in the second portion (56) of the opening, wherein a lateral dimension of the second thickness is greater than the first lateral opening dimension;
**characterized in that**
said body opening further including a third portion (46) having a third lateral opening dimension, wherein the second lateral opening dimension being larger than the first and the third lateral opening dimension, and the second portion (56) defining a lateral extending recess between the first and third portion (36, 46).

2. The microelectronic substrate of claim 1, further comprising a microelectronic component (12) mounted on the mounting site and electrically coupled to the substrate.

3. The microelectronic substrate of claim 1 or 2, wherein the body (25) includes a patterned electrically conductive layer (55) between the front and back surfaces (22, 24).

4. The microelectronic substrate of any of claim 1 to 3, wherein the body (25) includes a patterned electrically conductive layer (55) between the front and back surfaces (22, 24) and the electrically conductive layer (55) is thermally coupled to the thermally conductive member (100).

5. The microelectronic substrate of any of claims 1 to 4, wherein the second thickness of the thermally conductive member (100) is received in the transversely extending recess.

6. The microelectronic substrate of any of claims 1 to 5, wherein the second thickness of the thermally conductive member (100) comprises a radially extending flange.

7. The microelectronic substrate of any of claims 1 to 6, wherein the second thickness of the thermally conductive member (100) comprises a radially extending flange that extends about a periphery of the thermally conductive member (100).

8. The microelectronic substrate of any of claims 1 to 7, wherein the thermally conductive member (10) further comprises a third thickness and the second thickness is disposed between the first and third thicknesses.

9. The microelectronic substrate of any of claims 1 to 8, wherein the first and second thickness of the thermally conductive member (100) are integrally formed.

10. The microelectronic substrate of claim 1, wherein the substrate being a multi-layer printed circuit board, and said body (25) comprising:
a front body layer (30) having said first opening portion (36) therethrough;
an intermediate body layer (50) juxtaposed with the front body layer (30) and having said second opening portion (56) therethrough;
a back body layer (40) juxtaposed with the intermediate body layer (50) and spaced from the front body layer (30), the back body layer (40) having said third opening portion (46) therethrough;
an electrically conductive layer (55) disposed between the front body layer (30) and the back body layer (40);
wherein said thermal conductive member being a thermally conductive slug (100) received in and extending between said first opening portion (36) and said second opening portion (56) and thermally coupled to the electrically conductive layer (55), the slug (100) including a lateral extending flange that is attached to the attachment surface.

11. The microelectronic substrate of claim 10, wherein the flange of the slug (100) is attached to the attachment surface by a thermally conductive cementitious material.

12. The microelectronic substrate of claim 10 or 11, wherein the slug is electrically coupled to the electrically conductive layer.

13. The microelectronic substrate of any of claims 10 to 12, wherein the flange of the slug is attached to the attachment surface by an electrically conductive cementitious material that also electrically couples the slug (100) to the electrically conductive layer (55).

14. A method of assembling a microelectronic substrate having a front surface (22), a back surface (24) and an opening outwardly at the front surface (22) and the back surface (24), said method comprising the step of assembling:
a front layer (30) having a first portion (36) with a first lateral opening dimension,
an intermediate body layer (50) including a second portion (56) having a second lateral opening dimension;
a back layer (40) having a third portion (46) with a third lateral opening dimension, wherein the second lateral opening dimension being larger than the first and the third lateral opening dimension, and the second portion (56) defining a lateral extending recess between the first and third portion (36, 46); and
a thermally conductive member (100), which has a thermal conductivity greater than a thermal conductivity of the body (25), received at least in part in the opening in the body (25), the thermally conductive member (100) having a first thickness received in the first portion (36) of the opening and a second thickness received in the second portion (56) of the opening, wherein a lateral dimension of the second thickness is greater than the first lateral opening dimension.

## Patentansprüche

1. Mikroelektronisches Substrat, umfassend:
einen Körper (25), der aufweist:
eine vordere Oberfläche (22), die eine dem Montieren einer mikroelektronischen Komponente dienende Stelle beinhaltet, die dafür ausgelegt ist, eine mikroelektronische Komponente aufzunehmen,
eine hintere Oberfläche (24), die von der vorderen Oberfläche (22) um eine Dicke (T) getrennt ist, und
eine Öffnung, die an der vorderen Oberfläche (22) und der hinteren Oberfläche (24) nach außen offen ist und einen ersten Abschnitt (36) mit einer ersten seitlichen Öffnungsabmessung und einen zweiten Abschnitt (56) mit einer zweiten seitlichen Öffnungsabmessung aufweist; und
ein thermisch leitfähiges Element (100), das eine thermische Leitfähigkeit, die größer als eine thermische Leitfähigkeit des Körpers (25) ist, aufweist und wenigstens teilweise in der Öffnung in dem Körper (25) aufgenommen ist, wobei das thermisch leitfähige Element (100) eine erste Dicke, die in dem ersten Abschnitt (36) der Öffnung aufgenommen ist, und eine zweite Dicke, die in dem zweiten Abschnitt (56) der Öffnung aufgenommen ist, aufweist, wobei eine seitliche Abmessung der zweiten Dicke größer als die erste seitliche Öffnungsabmessung ist;
**dadurch gekennzeichnet, dass**
die Körperöffnung des Weiteren einen dritten Abschnitt (46) mit einer dritten seitlichen Öffnungsabmessung beinhaltet, wobei die zweite seitliche Öffnungsabmessung größer als die erste und die dritte seitliche Öffnungsabmessung ist und der zweite Abschnitt (56) eine sich seitlich erstreckende Ausnehmung zwischen dem ersten und dritten Abschnitt (36, 46) festlegt.

2. Mikroelektronisches Substrat nach Anspruch 1, des Weiteren umfassend eine mikroelektronische Komponente (12), die an der Montierstelle montiert und mit dem Substrat elektrisch gekoppelt ist.

3. Mikroelektronisches Substrat nach Anspruch 1 oder 2, wobei der Körper (25) eine gemusterte elektrisch leitfähige Schicht (55) zwischen den vorderen und hinteren Oberflächen (22, 24) beinhaltet.

4. Mikroelektronisches Substrat nach einem der Ansprüche 1 bis 3, wobei der Körper (25) eine gemusterte elektrisch leitfähige Schicht (55) zwischen den vorderen und hinteren Oberflächen (22, 24) beinhaltet und die elektrisch leitfähige Schicht (55) thermisch mit dem thermisch leitfähigen Element (100) gekoppelt ist.

5. Mikroelektronisches Substrat nach einem der Ansprüche 1 bis 4, wobei die zweite Dicke des thermisch leitfähigen Elementes (100) in der sich quer erstreckenden Ausnehmung aufgenommen ist.

6. Mikroelektronisches Substrat nach einem der Ansprüche 1 bis 5, wobei die zweite Dicke des thermisch leitfähigen Elementes (100) einen sich radial erstreckenden Flansch aufweist.

7. Mikroelektronisches Substrat nach einem der Ansprüche 1 bis 6, wobei die zweite Dicke des thermisch leitfähigen Elementes (100) einen sich radial erstreckenden Flansch umfasst, der sich längs eines Umfanges des thermisch leitfähigen Elementes (100) erstreckt.

8. Mikroelektronisches Substrat nach einem der Ansprüche 1 bis 7, wobei das thermisch leitfähige Element (10) des Weiteren eine dritte Dicke umfasst und die zweite Dicke zwischen den ersten und dritten Dicken befindlich ist.

9. Mikroelektronisches Substrat nach einem der Ansprüche 1 bis 8, wobei die erste und zweite Dicke des thermisch leitfähigen Elementes (100) integral ausgebildet sind.

10. Mikroelektronisches Substrat nach Anspruch 1, wobei das Substrat eine Mehrschichtenleiterplatte ist und der Körper (25) umfasst:
eine vordere Körperschicht (30), durch die hindurch der erste Öffnungsabschnitt (36) ausgebildet ist;
eine zwischenliegende Körperschicht (50), die neben der vorderen Körperschicht (30) befindlich ist und durch die der zweite Öffnungsabschnitt (56) ausgebildet ist;
eine hintere Körperschicht (40), die neben der zwischenliegenden Körperschicht (50) befindlich und von der vorderen Körperschicht (30) beabstandet ist, wobei durch die hintere Körperschicht (40) der dritte Öffnungsabschnitt (46) ausgebildet ist;
eine elektrisch leitfähige Schicht (55), die zwischen der vorderen Körperschicht (30) und der hinteren Körperschicht (40) angeordnet ist;
wobei das thermisch leitfähige Element ein thermisch leitfähiger Passkörper (100) ist, der sich zwischen dem ersten Öffnungsabschnitt (36) und dem zweiten Öffnungsabschnitt (56) erstreckt und darin aufgenommenen ist und thermisch mit der elektrisch leitfähigen Schicht (55) gekoppelt ist, wobei der Passkörper (100) einen sich seitlich erstreckenden Flansch beinhaltet, der an der Anbringoberfläche angebracht ist.

11. Mikroelektronisches Substrat nach Anspruch 10, wobei der Flansch des Passkörpers (100) an der Anbringoberfläche durch ein thermisch leitfähiges zementartiges Material angebracht ist.

12. Mikroelektronisches Substrat nach Anspruch 10 oder 11, wobei der Passkörper elektrisch mit der elektrisch leitfähigen Schicht gekoppelt ist.

13. Mikroelektronisches Substrat nach einem der Ansprüche 10 bis 12, wobei der Flansch des Passkörpers an der Anbringoberfläche durch ein elektrisch leitfähiges zementartiges Material angebracht ist, das zudem den Passkörper (100) mit der elektrisch leitfähigen Schicht (55) elektrisch koppelt.

14. Verfahren zum Zusammensetzen eines mikroelektronischen Substrates, das eine vordere Oberfläche (22), eine hintere Oberfläche (24) und eine an der vorderen Oberfläche (22) und der hinteren Oberfläche (24) nach außen offene Öffnung aufweist, wobei das Verfahren umfasst:
die Schritte des Zusammensetzens
einer vorderen Schicht (30), die einen ersten Abschnitt (36) mit einer ersten seitlichen Öffnungsabmessung aufweist,
einer zwischenliegenden Körperschicht (50), die einen zweiten Abschnitt (56) mit einer zweiten seitlichen Öffnungsabmessung beinhaltet;
einer hinteren Schicht (40), die einen dritten Abschnitt (46) mit einer dritten seitlichen Öffnungsabmessung aufweist, wobei die zweite seitliche Öffnungsabmessung größer als die erste und die dritte seitliche Öffnungsabmessung ist und der zweite Abschnitt (56) eine sich seitlich erstreckende Ausnehmung zwischen dem ersten und dritten Abschnitt (36, 46) festlegt; und
eines thermisch leitfähigen Elementes (100), das eine thermische Leitfähigkeit, die größer als eine thermische Leitfähigkeit des Körpers (25) ist, aufweist und wenigstens teilweise in der Öffnung in dem Körper (25) aufgenommen ist, wobei das thermisch leitfähige Element (100) eine erste Dicke, die in dem ersten Abschnitt (36) der Öffnung aufgenommen ist, und eine zweite Dicke, die in dem zweiten Abschnitt (56) der Öffnung aufgenommen ist, aufweist, wobei eine seitliche Abmessung der zweiten Dicke größer als die erste seitliche Öffnungsabmessung ist.

## Revendications

1. Substrat micro-électronique comprenant :
un corps (25) ayant
une surface avant (22) qui comprend un site de montage de composant micro-électronique configuré pour recevoir un composant micro-électronique,
une surface arrière (24) séparée de la surface avant (22) par une épaisseur (T), et
une ouverture s'ouvrant vers l'extérieur au niveau de la surface avant (22) et de la surface arrière (24), et ayant une première partie (36) ayant une première dimension d'ouverture latérale, et une deuxième partie (56) ayant une deuxième dimension d'ouverture latérale ; et
un élément thermoconducteur (100), qui a une conductivité thermique supérieure à une conductivité thermique du corps (25), reçu au moins partiellement dans l'ouverture dans le corps (25), l'élément thermoconducteur (100) ayant une première épaisseur reçue dans la première partie (36) de l'ouverture et une deuxième épaisseur reçue dans la deuxième partie (56) de l'ouverture, dans lequel une dimension latérale de la deuxième épaisseur est supérieure à la première dimension d'ouverture latérale ;
**caractérisé en ce que**
ladite ouverture de corps comprend en outre une troisième partie (46) ayant une troisième dimension d'ouverture latérale, dans lequel la deuxième dimension d'ouverture latérale est supérieure à la première dimension d'ouverture latérale et à la troisième dimension d'ouverture latérale, et la deuxième partie (56) définit un évidement s'étendant latéralement entre les première et troisième parties (36, 46).

2. Substrat micro-électronique selon la revendication 1, comprenant en outre un composant micro-électronique (12) monté sur le site de montage et couplé électriquement au substrat.

3. Substrat micro-électronique selon la revendication 1 ou 2, dans lequel le corps (25) comprend une couche à motifs électriquement conductrice (55) entre les surfaces avant et arrière (22, 24).

4. Substrat micro-électronique selon l'une quelconque des revendications 1 à 3, dans lequel le corps (25) comprend une couche à motifs électriquement conductrice (55) entre les surfaces avant et arrière (22, 24) et la couche électriquement conductrice (55) est couplée thermiquement à l'élément thermoconducteur (100).

5. Substrat micro-électronique selon l'une quelconque des revendications 1 à 4, dans lequel la deuxième épaisseur de l'élément thermoconducteur (100) est reçue dans l'évidement s'étendant transversalement.

6. Substrat micro-électronique selon l'une quelconque des revendications 1 à 5, dans lequel la deuxième épaisseur de l'élément thermoconducteur (100) comprend une bride s'étendant radialement.

7. Substrat micro-électronique selon l'une quelconque des revendications 1 à 6, dans lequel la deuxième épaisseur de l'élément thermoconducteur (100) comprend une bride s'étendant radialement qui s'étend autour d'une périphérie de l'élément thermoconducteur (100).

8. Substrat micro-électronique selon l'une quelconque des revendications 1 à 7, dans lequel l'élément thermoconducteur (10) comprend en outre une troisième épaisseur et la deuxième épaisseur est disposée entre les première et troisième épaisseurs.

9. Substrat micro-électronique selon l'une quelconque des revendications 1 à 8, dans lequel les première et deuxième épaisseurs de l'élément thermoconducteur (100) sont formées de manière intégrale.

10. Substrat micro-électronique selon la revendication 1, dans lequel le substrat est une carte de circuits imprimés à plusieurs couches, et ledit corps (25) comprend :
une couche de corps avant (30) traversée par ladite première partie d'ouverture (36) ;
une couche de corps intermédiaire (50) juxtaposée à la couche de corps avant (30) et traversée par ladite deuxième partie d'ouverture (56) ;
une couche de corps arrière (40) juxtaposée à la couche de corps intermédiaire (50) et espacée de la couche de corps avant (30), la couche de corps
arrière (40) étant traversée par ladite troisième partie d'ouverture (46) ;
une couche électriquement conductrice (55) disposée entre la couche de corps avant (30) et la couche de corps arrière (40) ;
dans lequel ledit élément thermoconducteur est un noyau thermoconducteur (100) reçu dans et s'étendant entre ladite première partie d'ouverture (36) et ladite deuxième partie d'ouverture (56) et couplé thermiquement à la couche électriquement conductrice (55), le noyau (100) comprenant une bride s'étendant latéralement qui est attachée à la surface d'attachement.

11. Substrat micro-électronique selon la revendication 10, dans lequel la bride du noyau (100) est attachée à la surface d'attachement par un matériau cimentaire thermoconducteur.

12. Substrat micro-électronique selon la revendication 10 ou 11, dans lequel le noyau est couplé électriquement à la couche électroconductrice.

13. Substrat micro-électronique selon l'une quelconque des revendications 10 à 12, dans lequel la bride du noyau est attachée à la surface d'attachement par un matériau cimentaire électroconducteur qui couple électriquement le noyau (100) à la couche électriquement conductrice (55).

14. Procédé d'assemblage d'un substrat micro-électronique ayant une surface avant (22), une surface arrière (24) et une ouverture s'ouvrant vers l'extérieur au niveau de la surface avant (22) et de la surface arrière (24), ledit procédé comprenant l'étape d'assemblage de :
une couche avant (30) ayant une première partie (36) avec une première dimension d'ouverture latérale,
une couche de corps intermédiaire (50) comprenant une deuxième partie (56) ayant une deuxième dimension d'ouverture latérale ;
une couche arrière (40) ayant une troisième partie (46) avec une troisième dimension d'ouverture latérale, dans lequel la deuxième dimension d'ouverture latérale est supérieure à la première dimension d'ouverture latérale et à la troisième dimension d'ouverture latérale, et la deuxième partie (56) définit un évidement s'étendant latéralement entre les première et troisième parties (36, 46) ; et
un élément thermoconducteur (100), qui a une conductivité thermique supérieure à une conductivité thermique du corps (25), reçu au moins partiellement dans l'ouverture dans le corps (25), l'élément thermoconducteur (100) ayant une première épaisseur reçue dans la première partie (36) de l'ouverture et une deuxième épaisseur reçue dans la deuxième partie (56) de l'ouverture, dans lequel une dimension latérale de la deuxième épaisseur est supérieure à la première dimension d'ouverture latérale.
